# EUROPÄISCHE PATENTANMELDUNG

(11) **EP 1 988 629 A2**
(43) Veröffentlichungstag der Anmeldung: **05.11.2008**
(21) Anmeldenummer: 08008419.7
(22) Anmeldetag: 05.05.2008
(51) Int. Cl.: H03F 3/45

(54) **Integrierter Verstärkerschaltkreis**

(30) Priorität: 04.05.2007 DE 102007021402
(71) Anmelder: ATMEL Germany GmbH, 74072 Heilbronn (DE)
(72) Erfinder: Kraus, Martin, 74182 Obersulm (DE); Schwarzmueller, Marco, 74080 Heilbronn (DE)
(74) Vertreter: Müller, Wolf-Christian

(57) **Zusammenfassung**

Die Erfindung betrifft einen integrierten Verstärkerschaltkreis mit zumindest zwei Verstärkern (10), die jeweils aus zumindest zwei punktsymmetrisch zueinander angeordneten Verstärkerbereichen (32,34) gebildet sind.
Erfindungsgemäß ist vorgesehen, dass jeder Verstärkerbereich (32,34) zumindest zwei Transistoren aufweist.

## Beschreibung

Die vorliegende Erfindung betrifft einen integrierten Verstärkerschaltkreis mit zumindest zwei Verstärkern, die jeweils aus zumindest zwei punktsymmetrisch zueinander angeordneten Verstärkerbereichen gebildet sind.

Ein bekannter integrierter Verstärkerschaltkreis weist zwei Verstärker auf, die jeweils in zwei Verstärkerbereiche unterteilt sind, wobei jeder der beiden Verstärker zwei elektrisch miteinander gekoppelte Transistoren aufweist, die räumlich getrennt voneinander angeordnet sind.

Der bekannte Verstärkerschaltkreis ist als Halbleiterbaustein verwirklicht. Dazu wird auf einem Grundsubstrat, beispielsweise auf einem Halbleiterkristall, ein geometrisch strukturierter Schichtaufbau mehrerer Schichten mit unterschiedlichen elektrischen Eigenschaften und unterschiedlichen Geometrien verwirklicht, wodurch die elektrischen Bauelemente der Verstärker gebildet werden.

Bei der Herstellung des Grundsubstrats und bei der nachfolgenden Aufbringung und Strukturierung der Schichten kann es zu prozessbedingten Inhomogenitäten im Hinblick auf die elektrischen Eigenschaften der einzelnen Schichten des Halbleiterbausteins kommen. Derartige Inhomogenitäten können die angestrebte Gleichartigkeit der Verstärker negativ beeinflussen. Aus diesem Grund ist es bekannt, die Verstärker in zwei Verstärkerbereiche aufzuteilen, die räumlich getrennt verwirklicht sind. Diese räumliche Trennung ermöglicht eine zumindest teilweise Kompensation von üblicherweise linear über die Oberfläche des Grundsubstrats veränderlichen Eigenschaften des Grundsubstrats und des Schichtaufbaus, die auch als Eigenschafts-Gradienten bezeichnet werden.

Eine bekannte Anordnung von zwei Verstärkern, die jeweils in zwei Verstärkbereiche unterteilt sind, wird als "common centroid"-Anordnung bezeichnet. Dabei sind die Verstärkerbereiche beider Verstärker punktsymmetrisch zu einem gemeinsamen Symmetriepunkt angeordnet und nehmen jeweils eine quadratische Fläche ein. Eine derartige Anordnung ist aus der Druckschrift US 2005/ 0026322 A1 bekannt.

Für bestimmte Anwendungen eines integrierten Verstärkerschaltkreises, bei denen eine besonders geringe Abweichung zwischen den Eigenschaften der Verstärker gefordert wird, ist die bekannte Anordnung bezüglich der Kompensation von Inhomogenitäten des Halbleiterbausteins nicht ausreichend.

Aufgabe der vorliegenden Erfindung ist es, einen integrierten Verstärkerschaltkreis bereitzustellen, bei dem die Verstärker zumindest nahezu identische elektrische Eigenschaften aufweisen.

Diese Aufgabe wird erfindungsgemäß durch einen integrierten Verstärkerschaltkreis mit den Merkmalen des Anspruchs 1 gelöst. Vorteilhafte Weiterbildungen der Erfindung sind Gegenstand von Unteransprüchen.

Hierzu werden bei dem integrierten Verstärkerschaltkreis der eingangs genannten Art mit einem Verstärker der zumindest aus zwei Verstärkerbereichen aufweist, und die Verstärkerbereiche um einen Symmetriepunkt angeordnet sind , und jeder Verstärkerbereich mehrere in Transistorbereichen angeordnete Transistoren aufweist, die Transistoren aus verschiedenen Verstärkerbereichen innerhalb eines gleichen Transistorbereichs angeordnet. Ferner weist bei dem integrierten Verstärkerschaltkreis der eingangs genannten Art jeder Verstärkerbereich zumindest zwei Transistoren auf. Die jeweils einander zugeordneten Transistoren können unmittelbar benachbart oder mit Abstand zueinander angeordnet werden. Dadurch wird eine zusätzliche räumliche Aufteilung für jeden der Verstärkerbereiche erreicht, durch die eine Mittelung der Eigenschafts-Gradienten stattfindet. Damit werden homogenere Eigenschaften für die Verstärkerbereiche und somit für die Verstärker erreicht. Das heißt, dass die Transistoren derart in den Verstärkerbereichen angeordnet sind, dass produktionstechnisch bedingte Eigenschafts-Gradienten zumindest im Wesentlichen kompensiert werden.

In einer Weiterbildung weist jeder Transistorbereich eine Symmetrieachse auf, wobei die Transistoren aus unterschiedlichen Verstärkerbereichen innerhalb eines Transistorbereichs entlang der Symmetrieachse angeordnet sind.

In weiterer Ausgestaltung der Erfindung ist vorgesehen, dass Verstärkerbereiche benachbarter Verstärker spiegelsymmetrisch zueinander angeordnet sind. Jeder der Verstärkerbereiche weist eine Außenkontur, also eine von den elektronischen Bauelementen des jeweiligen Verstärkerbereichs bestimmte Umrandungslinie auf. Die Außenkontur eines ersten Verstärkerbereichs entspricht erfindungsgemäß der Außenkontur eines benachbarten zweiten Verstärkbereichs, der seinerseits einem anderen Verstärker zugehörig ist. Die Außenkonturen der benachbarten Verstärkerbereiche können durch eine Spiegeloperation um eine Spiegelachse deckungsgleich aufeinander abgebildet werden. Damit kann bei Annahme von im Wesentlichen linear verlaufenden Eigenschafts-Gradienten auf dem Halbleiterbaustein eine günstige Mittelung der Eigenschaften der einzelnen Verstärkerbereiche erreicht werden.

In weiterer Ausgestaltung der Erfindung ist vorgesehen, dass Transistoren benachbarter Verstärker spiegelsymmetrisch zueinander angeordnet sind. Die Transistoren der jeweiligen Verstärkerbereiche weisen eine vorgebbare elektrische Verschaltung auf, die so gewählt ist, dass an mehrere Transistoren das gleiche Eingangssignal bereitgestellt wird. Damit lässt sich für diese Transistoren eine funktionale Position für den jeweiligen Verstärker zuordnen. Die funktionale Position der Transistoren ist erfindungsgemäß derart gewählt, dass Transistoren mit gleicher funktionaler Position bei benachbarten Verstärkerbereichen unterschiedlicher Verstärker an spiegelsymmetrisch gleichen geometrischen Positionen angeordnet sind. Damit wird für die Verstärker eine weitere Homogenisierung der Eigenschaften des Halbleiterbausteins verwirklicht. Vorzugsweise verlaufen Spiegelachsen für die Transistoren der Verstärkerbereiche durch einen gemeinsamen Symmetriepunkt der Verstärker.

In weiterer Ausgestaltung der Erfindung ist vorgesehen, dass die Transistoren in den Verstärkerbereichen spiegelsymmetrisch zueinander angeordnet sind. Die Transistoren in einem Verstärkerbereich sind unterschiedlichen Eingängen des Verstärkers zugeordnet, so dass sie mit gegebenenfalls voneinander abweichenden Eingangssignalen versorgt werden können. Um eine möglichst homogene Verarbeitung der Eingangssignale zu erreichen, sind die Transistoren, die jeweils gleichen Eingängen zugeordnet sind, jeweils spiegelsymmetrisch zueinander angeordnet. Dabei umfasst eine spiegelsymmetrische Anordnung der Transistoren sowohl den ersten Fall, dass Transistoren bei der Spiegeloperation aufeinander abgebildet werden als auch den zweiten Fall, dass Transistoren bei der Spiegeloperation auf sich selbst abgebildet werden. Eine Abbildung auf sich selbst findet statt, wenn die Spiegelachse durch den oder die Transistoren verläuft. Vorzugsweise verläuft eine Spiegelachse für die Transistoren eines Verstärkerbereichs durch einen Symmetriepunkt der Verstärkerbereiche.

In weiterer Ausgestaltung der Erfindung ist vorgesehen, dass die Verstärker als Differenzverstärker geschaltet sind. Bei einem Differenzverstärker wird eine Spannungsdifferenz zwischen zwei elektrischen Spannungen verstärkt, die an die zugeordneten Verstärker angelegt sind. Bei dem erfindungsgemäßen Verstärkerschaltkreis wird durch die vorteilhafte Ausgestaltung mit mehreren Transistoren in Transistorgruppen und die symmetrische Anordnung der Transistoren eine Angleichung der Verstärkungsfaktoren der Verstärker erreicht, die kleiner 0,5 Prozent, vorzugsweise kleiner 0,25 Prozent, besonders bevorzugt kleiner 0,1 Prozent beträgt.

In weiterer Ausgestaltung der Erfindung ist vorgesehen, dass zwischen den Verstärkerbereichen Leerbereiche angeordnet sind. Durch die Leerbereiche können unerwünschte elektrische Kopplungen zwischen benachbarten Verstärkerbereichen reduziert werden. Bei bekannten Verstärkern wird zur Erzielung möglichst homogener Verhältnisse eine möglichst dichte Anordnung der Verstärkerbereiche zueinander angestrebt. Bei dem erfindungsgemäßen Verstärkerschaltkreis kann eine Beabstandung und somit eine Entkopplung der Verstärkerbereiche durch Leerbereiche verwirklicht werden, da durch die symmetrische Anordnung der Transistoren in den Verstärkerbereichen und durch die symmetrische Anordnung der Verstärkerbereiche ohnehin eine Homogenisierung der Eigenschafts-Gradienten auf dem Halbleiterbaustein erfolgt.

In weiterer Ausgestaltung der Erfindung ist vorgesehen, dass die Verstärkerbereiche, insbesondere die Transistoren, gemäß einer vierzähligen Punktsymmetrie angeordnet sind. Damit wird insbesondere für einen Differenzverstärker, der zwei miteinander gekoppelte Verstärker aufweist, die in Verstärkerbereiche und in einzelne Transistoren unterteilt sein können, eine vorteilhafte Anordnung erreicht. Bei einer vierzähligen Punktsymmetrie kann jeder der Verstärkerbereiche durch Schwenkbewegungen mit einem Schwenkwinkel von 90 Grad um einen Symmetriepunkt auf jeden der übrigen Verstärkerbereiche passend abgebildet werden.

In weiterer Ausgestaltung der Erfindung ist vorgesehen, dass Transistoren elektrisch zu Transistorgruppen zusammengefasst sind und zumindest zwei Transistorgruppen eines Verstärkerbereichs einen gemeinsamen Zentrumspunkt aufweisen. Dabei werden Transistoren, die elektrisch an einem gemeinsamen Eingangsanschluss angekoppelt sind, als Transistorgruppe definiert. Die Transistoren einer Transistorgruppe sind vorzugsweise derart in den Verstärkerbereichen angeordnet, dass sie hinsichtlich der Verstärkerbereiche punktsymmetrisch angeordnet und innerhalb des jeweiligen Verstärkerbereichs spiegelsymmetrisch ausgerichtet sind. Da jeder der Transistoren eine, vorzugsweise gleiche, Fläche auf dem Halbleiterbaustein einnimmt, kann ein Zentrumspunkt oder ein Flächenmittelpunkt für alle Transistoren einer Transistorgruppe ermittelt werden. Erfindungsgemäß ist vorgesehen, dass Zentrumspunkte von zumindest zwei Transistorgruppen, die gleichen oder unterschiedlichen Verstärkern zugehörig sein können, in einem gemeinsamen Punkt zusammenfallen, da sich hiermit eine besonders vorteilhafte Homogenisierung von Eigenschafts-Gradienten eines Halbleiterbauelements erzielen lässt.

Weitere Vorteile und Merkmale der Erfindung ergeben sich aus den Ansprüchen sowie aus der nachfolgenden Beschreibung bevorzugter Ausführungsbeispiele, die anhand der Zeichnungen dargestellt sind. Dabei zeigt:
- Fig. 1: eine schematische Darstellung eines Verstärkers mit mehreren Eingängen,
- Fig. 2: eine schematische Darstellung eines internen Aufbaus des Verstärkers gemäß der Fig. 1,
- Fig. 3: eine detaillierte Darstellung eines Verstärkerbereichs gemäß der Fig. 2,
- Fig. 4: eine schematische Darstellung der Anordnung der Transistoren in einem Verstärkerschaltkreis, der aus zwei Verstärkern aufgebaut ist.

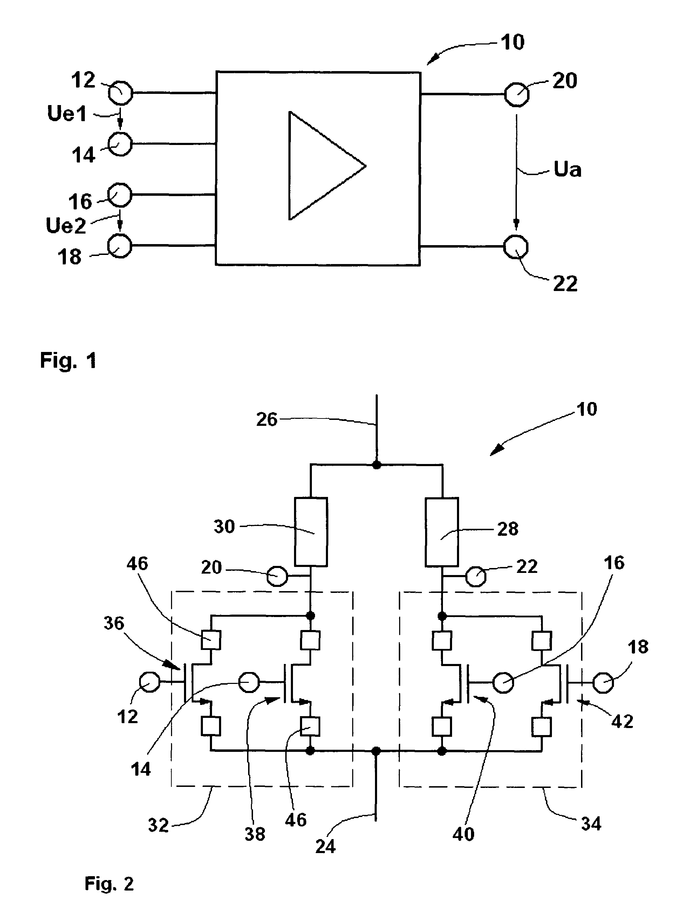

Ein in der Fig. 1 dargestellter Verstärker 10, der auf einem nicht näher dargestellten Halbleiterbaustein verwirklicht ist, weist vier Eingangsanschlüsse 12, 14, 16, 18 sowie zwei Ausgangsanschlüsse 20, 22 auf. An jeweils zwei benachbart zueinander angeordneten Eingangsanschlüssen 12 und 14 bzw. 16 und 18 werden beim Einsatz des Verstärkers 10 in einer nicht näher dargestellten elektronischen Schaltung Eingangsspannungen Ue1 und Ue2 angelegt. Der Verstärker 10 ist über nicht näher dargestellte Anschlüsse an eine Versorgungsspannung angeschlossen und gibt als Ausgangsspannung Ua eine elektrische Spannung aus, die sich als Produkt der jeweiligen Eingangsspannung Ue1 bzw. Ue2 mit einem zugehörigen, durch den jeweiligen Verstärkerbereich bestimmten Verstärkungsfaktor G1 bzw. G2 ergibt. Dabei wird der Verstärkungsfaktor G1 bzw. G2 von den elektrischen Eigenschaften der jeweiligen, in der Fig. 1 nicht näher dargestellten, Verstärkerbereiche innerhalb des Verstärkers 10 bestimmt.

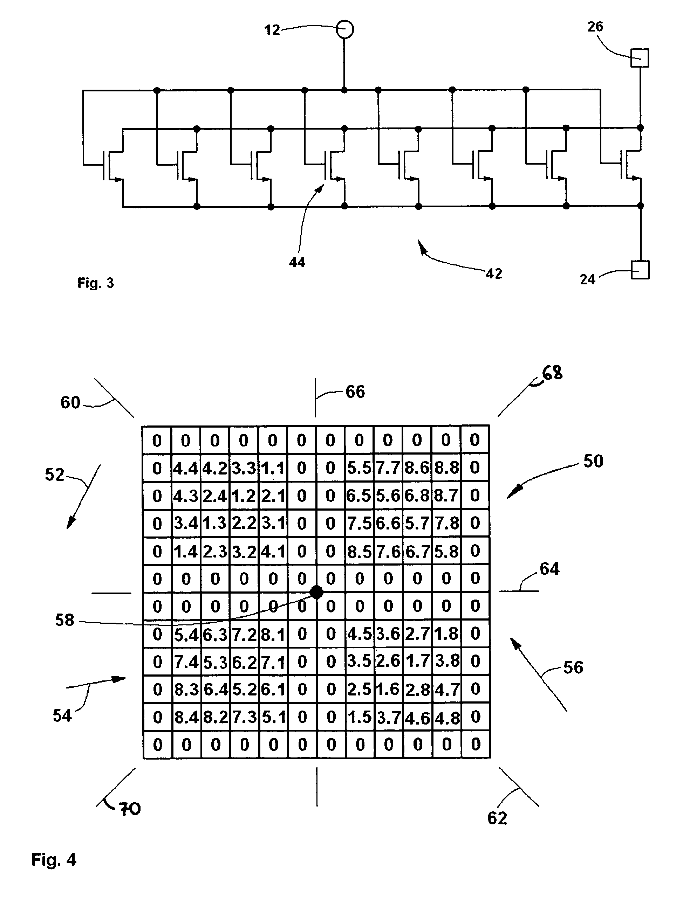

In der Fig. 2 ist der Verstärker 10 gemäß der Fig. 1 näher dargestellt. Der Verstärker 10 ist in zwei spiegelbildlich aufgebaute Verstärkerbereiche 32, 34 aufgeteilt, die jeweils zwei parallel geschaltete, mit einem Transistorschaltsymbol dargestellte Transistorgruppen 36, 38 bzw. 40, 42 aufweisen. Jede der Transistorgruppen 36, 38, 40, 42 ist, wie in der Fig. 3 näher dargestellt wird, aus acht Transistoren 44 aufgebaut und ist über Verbindungsknoten 46 an den Versorgungsanschlüssen 24, 26 angeschlossen. Zudem ist jede der Transistorgruppen 36, 38, 40, 42 mit einem der Eingangsanschlüsse 12, 14, 16, 18 verbunden, während die Ausgangsanschlüsse 20 und 22 jeweils an den Vorwiderständen 28, 30 anschlossen sind. An den Eingangsanschlüssen 12, 14, 16, 18 anliegende elektrische Potentiale dienen als Steuerspannungen für die jeweils zugeordneten Transistorgruppen 36, 38 40 42.

Bei Anlegen unterschiedlicher Eingangsspannungen Ue1 und Ue2 an die Eingangsanschlüsse 12, 14, 16, 18 stellt sich für jeden der als NMOS-Feldeffekttransistoren ausgeführten Transistoren ein vom jeweiligen elektrischen Potential der angelegten Eingangsspannung abhängiger Strom ein. Dieser Strom fließt über den jeweiligen Vorwiderstand 28, 30. Eine Spannungsdifferenz zwischen den Eingangsspannungen Ue1 und Ue2 äußert sich dementsprechend als Potentialdifferenz zwischen den beiden Vorwiderständen 28, 30. Diese Potentialdifferenz kann über die Ausgangsanschlüsse 20, 22 zur weiteren Verarbeitung abgegriffen werden.

Wie in der Fig. 3 näher dargestellt wird, ist jede Transistorgruppe 36, 38, 40, 42 als Anordnung aus acht Transistoren 44 aufgebaut, die parallel zueinander geschaltet sind. Die Transistoren 44 sind entsprechend einer in der Fig. 4 näher dargestellten Verteilung angeordnet, um eine möglichst weitgehende Kompensation von Eigenschafts-Gradienten des nicht näher dargestellten Halbleiterbausteins zu ermöglichen. In der Fig. 4 werden die Transistoren 44 mit einer Ziffernkombination gekennzeichnet, wobei die erste Ziffer die Zugehörigkeit zu der jeweiligen Transistorgruppe 36, 38, 40, 42 bezeichnet, während die zweite Ziffer hinter dem Dezimalpunkt die fortlaufende Nummer des Transistors 44 innerhalb der jeweiligen Transistorgruppe bezeichnet.

In der Fig. 4 ist ein Verstärkerschaltkreis 50 mit zwei Verstärkern dargestellt, von denen jeder vier Transistorgruppen mit je acht Transistoren 44 aufweist, so dass der Verstärkerschaltkreis 50 insgesamt vierundsechzig Transistoren 44 enthält. Bei einer exemplarischen Betrachtung der ersten Transistorgruppe, die aus den Transistoren 1.1 bis 1.8 aufgebaut ist, können die für die homogenen Eigenschaften des Verstärkerschaltkreises relevanten Symmetriebedingungen erläutert werden.

Die Transistoren 44 der ersten Transistorgruppe sind derart in dem Verstärkerschaltkreis 50 angeordnet, dass die Transistoren 1.1 bis 1.4 durch eine Rotation um eine senkrecht zur Zeichenebene ausgerichtete und durch einen Symmetriepunkt 58 verlaufende Rotationsachse eine Abbildung auf die jeweils zugehörigen Transistoren 1.5 bis 1.8 abgegeben werden können. Das heißt beispielsweise, dass der mit 1.1 bezeichnete Transistor 44 bei einer Rotation um 180 Grad auf den mit 1.5 bezeichneten Transistor 44 abgebildet werden kann. Weiterhin sind die Transistoren 44 innerhalb der Transistorgruppen derart ausgerichtet, dass sie bei Spiegelung um die Spiegelachsen 60, 62, die in der Zeichnungsebene jeweils als Diagonalen des dargestellten Quadrats durch den Symmetriepunkt 58 verlaufen, jeweils wieder auf Transistoren 44 gespiegelt werden, die zur gleichen Transistorgruppe gehören. Manche der Transistoren 44 werden durch eine derartige Spiegeloperation auch auf sich selbst abgebildet, wie dies exemplarisch für den Transistor 4.1 bei Spiegelung um die Spiegelachse 60 der Fall ist.

Die Transistoren 44 der jeweiligen Transistorgruppen sind derart angeordnet, dass sie mehrere Symmetriebedingungen erfüllen, wodurch gewährleistet wird, dass Eigenschafts-Gradienten, wie sie durch die Pfeile 52, 54 und 56 angedeutet werden, zumindest nahezu vollständig kompensiert werden können. Derartige Eigenschafts-Gradienten treten bedingt durch Produktionsprozesse für die Halbleiterbauelemente auf und können beispielsweise auf eine inhomogene Bedampfung der Oberfläche des Substratmaterials während der Herstellung der Halbleiterbauelemente auftreten. Eigenschafts-Gradienten können beispielsweise die elektrische Leitfähigkeit betreffen, die in linearer Weise in Richtung des Pfeils 52 zunimmt. Somit hat exemplarisch der Transistor 8.4 andere elektrische Leitfähigkeitseigenschaften als der Transistor 8.8. Da jedoch beide Transistoren zur gleichen Transistorgruppe zugehörig sind und mit dem gleichen Eingangssignal beaufschlagt werden, kommt es zu einer Mittelung der elektrischen Eigenschaften und somit zur gewünschten Eigenschafts-Kompensation der Eigenschafts-Gradienten.

Die Transistoren 44 sind in Transistorbereichen jeweils mit einer quadratischen Außenkontur und in einem Raster mit konstanter Teilung angeordnet, so dass jeder der Transistoren 44 die gleiche quadratische Fläche auf dem Halbleiterbaustein einnimmt. Benachbarte Transistorbereiche können durch Spiegelung aufeinander abgebildet werden. Dabei ist sowohl eine Überlagerung der Außenkonturen der jeweiligen Transistorbereiche als auch eine passende Abbildung der Transistoren 44 innerhalb der Transistorbereiche gewährleistet. Das heißt, bei einer Spiegelung um eine der Spiegelachsen 64, 66 kann beispielsweise der Transistorbereich mit den Transistoren 1.1 bis 4.4 auf den benachbarten Transistorbereich mit den Transistoren 5.1 bis 8.4 oder auf den Transistorbereich mit den Transistoren 5.5 bis 8.8 abgebildet werden.

Alle Transistoren 44 der Transistorgruppen in dem Verstärkerschaltkreis 50 weisen einen gemeinsamen Flächenschwerpunkt auf, der mit dem Symmetriepunkt 58 zusammenfällt. Exemplarisch kann dies anhand der ersten Transistorgruppe mit den Transistoren 1.1 bis 1.8 nachvollzogen werden. Da diese Symmetriebedingung auch für die übrigen Transistorgruppen gilt und alle Flächenschwerpunkte der Transistorgruppen in dem Symmetriepunkt 58 zusammenfallen, ergibt sich eine besonders ausgewogene Kompensation der Eigenschafts-Gradienten über den Halbleiterbaustein.

Die Anordnung der Transistoren 44 in den vier Transistorbereichen erfüllt auch innerhalb des jeweiligen Transistorbereichs wenigstens eine weitere Symmetriebedingung. Wie weiter oben ausgeführt, weist die erste Ziffer 1 und 2, der Transistoren 44, auf eine Zugehörigkeit der Transistoren zu der Transistorgruppe 36 und 38 hin. Demgemäß sind diese Transistoren sämtlich dem Verstärkerbereich 32 zugeordnet. Entsprechend weist die Ziffer 3. und 4. der Transistoren 44 auf eine Zugehörigkeit der Transistoren zu der Transistorgruppe 40 und 42 des Verstärkerbereichs 34 hin. Damit enthält jeder der vier Transistorbereiche Transistoren 44 aus jeweils beiden Verstärkerbereichen 32, 34 wie beispielsweise der Transistorbereich mit der Spiegelachse 60 die Transistoren 4.4 und 2.4 beinhaltet.

Des weiteren sind innerhalb des jeweiligen Transistorbereichs die Transistoren 44 entlang einer Achse, die als Symmetrieachse, vorzugsweise als Spiegelachse 60, 62 68, 70 ausgebildet ist, angeordnet. Beispielsweise sind entlang der Spiegelachse 60 die Transistoren 4.4, 4.3, 4.2, 3.3, 2.4, 3.4, 1.4, 1.3, 1.2, 1.1, 2.1, 2.2, 2.3, 3.2, 3.1, und 4.1 angeordnet. Es zeigt sich, dass die Transistoren, die eine gleiche erste Ziffer aufweisen, wie beispielsweise die Transistoren 3.4 und 3.3 gespiegelt an der Spiegelachse 60, angeordnet sind. Ferner zeigt sich, dass grundsätzlich die Transistoren mit der gleichen Anfangsziffer entlang einer Achse angeordnet sind, die senkrecht auf der jeweiligen Spiegelachse 60, 62, 68, 70 steht, sofern die Transistoren nicht direkt auf den Spiegelachsen 60, 62, 68, 70 angeordnet sind.
Ferner weisen die vier Transistorbereiche, die jeweils eine diagonal verlaufene Spiegelachse 60, 62, 68, 70 umfassen, eine quadratische Anordnung der darin enthaltenen Transistoren auf. Zwischen den vier Transistorbereichen und an den Außenseiten der Transistorbereiche sind Leerbereiche, in der Figur 4 mit Hilfe der Zahl "0" dargestellt, angeordnet, wobei die zwischen den Transistorbereichen liegenden Leerbereiche jeweils spiegelsymmetrisch zu einer der Spiegelachsen 64 bzw. 66 angeordnet sind. Die Spiegelachsen verlaufen jeweils durch den Symmetriepunkt 58. Demgemäß sind jeweils zwei der Transistorbereich spiegelbildlich zu einer der Spiegelachsen 64 oder 66 angeordnet.

Durch diese hochsymmetrische Anordnung der Transistoren 44 des Differenzverstärkers, die wie oben ausgeführt, auch innerhalb der jeweiligen Transistorbereiche mehrere Symmetriebedingen erfüllen. Des weiteren lassen sich die Transistorbereiche durch drehen um 90° um eine senkrecht zu der Bildebene und durch den Symmetriepunkt 58 verlaufende Achse aufeinander abbilden, ebenso wie durch spiegeln an einer der Achsen 64 oder 66. Durch die erfindungsgemäße Anordnung lassen sich produktionsbedingte Bauteilstreuungen besonders stark unterdrücken.

### Bezugszeichenliste:

- 10: Verstärker
- 12: Eingangsanschluss
- 14: Eingangsanschluss
- 16: Eingangsanschluss
- 18: Eingangsanschluss
- 20: Ausgangsanschluss
- 22: Ausgangsanschluss
- 24: Versorgungsanschluss
- 26: Versorgungsanschluss
- 28: Vorwiderstand
- 30: Vorwiderstand
- 32: Verstärkerbereich
- 34: Verstärkerbereich
- 36: Transistorgruppe
- 38: Transistorgruppe
- 40: Transistorgruppe
- 42: Transistorgruppe
- 44: Transistor
- 46: Verbindungsknoten
- 50: Verstärkerschaltkreis
- 52: Eigenschafts-Gradient
- 54: Eigenschafts-Gradient
- 56: Eigenschafts-Gradient
- 58: Symmetriepunkt
- 60: Spiegelachse
- 62: Spiegelachse
- 64: Spiegelachse
- 66: Spiegelachse
- 68: Spiegelachse
- 70: Spiegelachse

## Patentansprüche

1. Integrierter Verstärkerschaltkreis mit einem Verstärker (10), der zumindest aus zwei Verstärkerbereichen (32, 34) gebildet wird, und die Verstärkerbereiche (32, 34) um einen Symmetriepunkt (58) angeordnet sind , jeder Verstärkerbereich (32, 34) mehrere in Transistorbereichen angeordnete Transistoren (44) aufweist,
**dadurch gekennzeichnet, dass**
Transistoren (44) aus verschiedenen Verstärkerbereichen (32,34) innerhalb eines gleichen Transistorbereichs angeordnet sind.

2. Integrierter Verstärkerschaltkreis nach Anspruch 1, **dadurch gekennzeichnet, dass** jeder Transistorbereich eine Symmetrieachse aufweist.

3. Integrierter Verstärkerschaltkreis nach Anspruch 1 oder 2, **dadurch gekennzeichnet, dass** wenigstens ein Teil der Transistoren (44) spiegelbildlich entlang der Symmetrieachse angeordnet sind.

4. Integrierter Verstärkerschaltkreis nach Anspruch 2 oder 3, **dadurch gekennzeichnet, dass** die Symmetrieachsen als Spiegelachsen (60, 62, 68, 70) ausgebildet ist.

5. Integrierter Verstärkerschaltkreis nach Anspruch 4, **dadurch gekennzeichnet, dass** alle Transistoren (44) in den Transistorbereichen spiegelsymmetrisch entlang der Spiegelachse (60, 62, 68, 70) angeordnet sind.

6. Integrierter Verstärkerschaltkreis nach Anspruch 3 oder 4, **dadurch gekennzeichnet, dass** die Spiegelachsen (64, 66, 68, 70) für die Transistorbereiche durch den Symmetriepunkt (58) des Verstärkers (10) verlaufen.

7. Integrierter Verstärkerschaltkreis nach einem der vorhergehenden Ansprüche, **dadurch gekennzeichnet, dass** der Verstärker (10) als Differenzverstärker geschaltet ist.

8. Integrierter Verstärkerschaltkreis nach einem der vorhergehenden Ansprüche, **dadurch gekennzeichnet, dass** zwischen den Transistorbereichen Leerbereiche angeordnet sind.

9. Integrierter Verstärkerschaltkreis nach einem der vorhergehenden Ansprüche, **dadurch gekennzeichnet, dass** die Transistoren (44) der Transistorbereiche gemäß einer vierzähligen Punktsymmetrie angeordnet sind.
